# FASCICULE DE BREVET EUROPEEN

(11) **EP 3 499 248 B1**
(45) Date de publication et mention de la délivrance du brevet: **20.11.2019**
(21) Numéro de dépôt: 18186466.1
(22) Date de dépôt: 31.07.2018
(51) Int. Cl.: G01R 15/18

(54) **DISPOSITIF DE MESURE DU COURANT ÉLECTRIQUE, APPAREIL DE MESURE DU COURANT ET PROCÉDÉ DE FABRICATION D'UN DISPOSITIF DE MESURE DU COURANT**
STROMSENSOR, STROMMESSEINHEIT UND VERFAHREN ZUM HERSTELLEN EINES STROMSENSORS
ELECTRIC CURRENT MEASURING DEVICE, CURRENT MEASURING UNIT AND METHOD FOR MANUFACTURING A CURRENT MEASURING DEVICE

(30) Priorité: 14.12.2017 FR 1762117
(43) Date de publication de la demande: 19.06.2019
(73) Titulaire: Schneider Electric Industries SAS, 92500 Rueil-Malmaison (FR)
(72) Inventeur: URANKAR, Lionel, 38050 Grenoble (FR)
(74) Mandataire: Tripodi, Paul

(56) Documents cités:
- EP-A1- 3 171 182
- WO-A1-01/57543
- US-A1- 2015 245 534
- US-B1- 6 426 617

## Description

### DOMAINE TECHNIQUE

La présente invention concerne un dispositif compact de mesure du courant électrique circulant dans des lignes de courant d'une installation électrique. L'invention concerne également un procédé de fabrication d'un tel dispositif de mesure et un appareil de mesure du courant électrique.

### ETAT DE LA TECHNIQUE

Un capteur de courant électrique est utilisé pour mesurer l'intensité d'un courant électrique circulant dans une ligne électrique. Une telle mesure est nécessaire pour quantifier la puissance et/ou l'énergie électrique consommée par un tel récepteur ou pour détecter une anomalie de fonctionnement du récepteur électrique. Un tel capteur est installé autour de la ligne de courant dans laquelle circule le courant à mesurer. Dans une installation industrielle, l'utilisation d'énergie électrique distribuée sous forme triphasée est largement répandue. Dans ce cas, un capteur de courant électrique doit être installé autour de chacune des trois phases. Etant donné que les équipements électriques sont de plus en plus compacts et que la densité des équipements dans une installation électrique est de plus en plus importante, il est nécessaire de disposer de capteurs de courant extrêmement compacts pour être installés dans ou à proximité d'un appareil de mesure ou d'un appareil de protection. De plus, pour assurer une conformité aux normes d'installation et une interchangeabilité des appareils, la distance entre les lignes ou conducteurs de courant est généralement imposée, par exemple 18, 25 ou encore 27 mm. Par conséquent, une implantation de capteurs de courant électrique autour de lignes de courant doit suivre les mêmes contraintes. D'autre part, dans une installation triphasée, la grande proximité entre les différentes lignes de courant et les capteurs de courant peut être source de perturbation des mesures de courant. En effet, un capteur de courant installé autour d'une ligne de courant peut être influencé par un champ magnétique créé par un courant circulant dans une autre ligne de courant située à proximité. Il convient donc de disposer de capteurs de courant compacts, précis et peu influencés par les perturbations externes.

Le document US 6 426 617 B1 divulgue un système de mesure de courant basé sur le principe Hall.

Le document EP 3 171 182 A1 divulgue un capteur de courant de type Rogowski comportant deux couches de bobines. Un tel capteur est peu sensible aux perturbations électromagnétiques et dispose d'une forme adaptée à une implantation dans un appareillage industriel compact.

Le document WO 01/57 543 A1 décrit un capteur de courant de Rogowski constitué de deux enroulements, chaque enroulement étant disposé sur une carte de circuit imprimé. Plusieurs capteurs de courant peuvent être réalisés côte à côte sur chaque carte de circuit imprimé.

### EXPOSE DE L'INVENTION

L'invention vise à accroître la compacité d'un ensemble de capteurs de courant destinés à mesurer l'amplitude du courant électrique circulant dans plusieurs lignes électriques sans dégrader la précision de mesure et sans accroitre la sensibilité aux perturbations externes.

Pour cela, l'invention décrit un dispositif de mesure du courant circulant dans au moins deux lignes de courant d'une installation électrique, comprenant :
- un premier ensemble de circuit imprimé comportant :
   - une première ouverture pour un passage d'une première ligne de courant,
   - une deuxième ouverture pour un passage d'une deuxième ligne de courant, et
   - un premier capteur de courant disposé autour de la première ouverture pour mesurer le courant circulant dans la première ligne de courant, ledit premier capteur de courant comportant au moins une première portion rectiligne d'enroulement disposée entre la première ouverture et la deuxième ouverture,
- un second ensemble de circuit imprimé, disposé parallèlement au premier ensemble de circuit imprimé, ledit second ensemble comportant :
   - une troisième ouverture, en vis-à-vis de la deuxième ouverture, pour un passage de la deuxième ligne de courant,
   - un deuxième capteur de courant disposé autour de la troisième ouverture pour mesurer le courant circulant dans la deuxième ligne de courant traversant la troisième ouverture, ledit deuxième capteur comportant au moins une deuxième portion rectiligne d'enroulement disposée en vis-à-vis de la première portion rectiligne d'enroulement du premier capteur de courant.

Préférentiellement, le dispositif de mesure du courant est tel que :
- le premier ensemble de circuit imprimé comporte une quatrième ouverture destinée au passage d'une troisième ligne de courant,
- un troisième capteur de courant, formé dans le premier ensemble de circuit imprimé, est disposé autour de la quatrième ouverture pour mesurer le courant circulant dans la troisième ligne de courant, et
- le troisième capteur de courant comporte au moins une troisième portion rectiligne d'enroulement disposée entre la deuxième ouverture et la quatrième ouverture.

Avantageusement, les premier, deuxième et troisième capteurs sont des capteurs de courant de type Rogowski.

Préférentiellement, le deuxième capteur de courant comporte une quatrième portion rectiligne d'enroulement disposée en vis-à-vis de la troisième portion rectiligne d'enroulement du troisième capteur de courant.

Avantageusement, le premier ensemble de circuit imprimé comporte des premières plages de soudure, le second ensemble de circuit imprimé comporte des secondes plages de soudure disposées en vis-à-vis des premières plages de soudure pour souder le second ensemble de circuit imprimé sur le premier ensemble de circuit imprimé de telle sorte que la deuxième portion rectiligne d'enroulement soit disposée en vis-à-vis de la première portion rectiligne d'enroulement et que la quatrième portion rectiligne d'enroulement soit disposée en vis-à-vis de la troisième portion rectiligne d'enroulement.

Préférentiellement, la somme des surfaces des plages de soudure du second ensemble de circuit imprimé est supérieure à 3% de la surface d'une face du second ensemble de circuit imprimé.

Préférentiellement, le premier ensemble de circuit imprimé est formé par un premier circuit imprimé collé à un deuxième circuit imprimé au moyen d'un premier tissu pré-imprégné de résine et le second ensemble de circuit imprimé est formé par un troisième circuit imprimé collé à un quatrième circuit imprimé au moyen d'un second tissu pré-imprégné de résine.

Avantageusement, le premier capteur de courant comprend un premier enroulement formé dans le premier circuit imprimé et comprend un deuxième enroulement formé dans le deuxième circuit imprimé, le premier enroulement et le deuxième enroulement ont un même encombrement et sont connectés en série, et le deuxième capteur de courant comprend un troisième enroulement formé dans le troisième circuit imprimé et comprend un quatrième enroulement formé dans le quatrième circuit imprimé, le troisième enroulement et le quatrième enroulement ont un même encombrement et sont connectés en série.

De préférence, les premier, deuxième, troisième et quatrième circuits imprimés sont fabriqués à partir d'une même plaque de circuit imprimé.

De préférence, la plaque de circuit imprimé a une épaisseur supérieure à 1,5 millimètre.

Avantageusement, le premier ensemble de circuit imprimé et le second ensemble de circuit imprimé comportent des faces recouvertes d'un verni épargne.

L'invention porte également sur un appareil de mesure du courant circulant dans, au moins, deux lignes de courant d'une installation électrique, ledit appareil de mesure comportant :
- un circuit de mesure pour mesurer l'amplitude de signaux électriques,
- un circuit de communication relié au circuit de mesure pour transmettre des résultats de mesure des signaux mesurés, et
- un circuit d'alimentation pour alimenter le circuit de mesure et le circuit de communication, et
- un dispositif de mesure du courant tel que décrit précédemment, connecté au circuit de mesure pour fournir au circuit de mesure des signaux représentatifs des courants circulant dans les, au moins deux, lignes de courant, une première ligne de courant passant dans une première ouverture du dispositif de mesure du courant et une deuxième ligne passant dans une deuxième ouverture et une troisième ouverture du dispositif de mesure du courant.

L'invention porte également sur un procédé de fabrication d'un dispositif de mesure du courant tel que décrit précédemment, ledit procédé comportant les étapes suivantes :
- la découpe d'une plaque mère de circuit imprimé en une première plaque destinée à la réalisation des premier et troisième circuits imprimés et une seconde plaque de circuit imprimé destinée à la réalisation des second et quatrième circuits imprimés,
- la première gravure, sur une première face de la première plaque, de premières pistes correspondant aux premier et troisième enroulements d'un premier et d'au moins un deuxième capteur de courant et la gravure sur la seconde plaque de circuit imprimé, de premières pistes correspondant aux deuxième et quatrième enroulements d'un premier et d'au moins un deuxième capteur de courant,
- le perçage et la métallisation de premiers vias pour connecter les premières pistes,
- le collage de la première plaque de circuit imprimé avec la seconde plaque de circuit imprimé au moyen d'un premier tissu pré-imprégné de résine, la première face de la première plaque étant en vis-à-vis de la première face de la seconde plaque de circuit imprimé,
- la seconde gravure, sur une seconde face de la première plaque, de secondes pistes correspondant aux premier et troisième enroulements et la gravure sur une seconde face la seconde plaque de circuit imprimé, de secondes pistes correspondant aux deuxième et quatrième enroulements,
- le perçage et la métallisation de seconds vias pour connecter les pistes entre la première face et la seconde face de la première plaque et de la seconde plaque de circuit imprimé,
- le dépôt d'un vernis épargne sur la seconde face de la première plaque et sur la seconde face de la seconde plaque de circuit imprimé,
- la découpe d'au moins une première et d'une deuxième ouverture,
- la découpe d'un premier ensemble de circuit imprimé et d'un second ensemble de circuit imprimé,
- le positionnement du second ensemble de circuit imprimé sur le premier ensemble de circuit imprimé de telle sorte qu'au moins une deuxième portion rectiligne d'enroulement du deuxième capteur de courant soit disposée en vis-à-vis d'une première portion rectiligne d'enroulement du premier capteur de courant, et
- la soudure du second ensemble de circuit imprimé sur le premier ensemble de circuit imprimé.

### BREVE DESCRIPTION DES DESSINS

D'autres avantages et caractéristiques ressortiront plus clairement de la description qui va suivre, de modes particuliers de réalisation de l'invention, donnés à titre d'exemples non limitatifs, et représentés aux dessins annexés sur lesquels :
- la figure 1 est une vue en perspective d'un dispositif de mesure du courant pour illustrer une disposition en vis-à-vis d'une première portion rectiligne d'enroulement d'un premier capteur de courant avec une deuxième portion rectiligne d'enroulement d'un deuxième capteur de courant, selon un premier mode de réalisation,
- la figure 2 est une vue en perspective d'un dispositif de mesure du courant pour illustrer une disposition en vis-à-vis de plusieurs portions rectilignes d'enroulement de plusieurs capteurs de courant selon un mode de réalisation préférentiel destiné à la mesure du courant dans un réseau triphasé,
- la figure 3 représente un exemple de disposition de plages de soudure entre un premier ensemble de circuit imprimé et un deuxième ensemble de circuit imprimé pour réaliser une disposition en vis-à-vis de plusieurs portions rectilignes d'enroulements de capteurs de courant,
- la figure 4A représente une vue éclatée du dispositif de mesure du courant représenté en figure 2,
- la figure 4B est une vue en perspective du dispositif de mesure du courant selon un mode de réalisation préférentiel destiné à la mesure du courant pour un réseau triphasé,
- la figure 5 représente des schémas de connexion des enroulements composant les capteurs de courant pour un dispositif de mesure du courant tel que représenté en figure 4B,
- la figure 6 représente un schéma bloc d'un appareil de mesure intégrant un dispositif de mesure du courant selon l'invention,
- la figure 7 représente une vue éclatée d'un appareil de mesure intégrant un dispositif de mesure du courant selon l'invention,

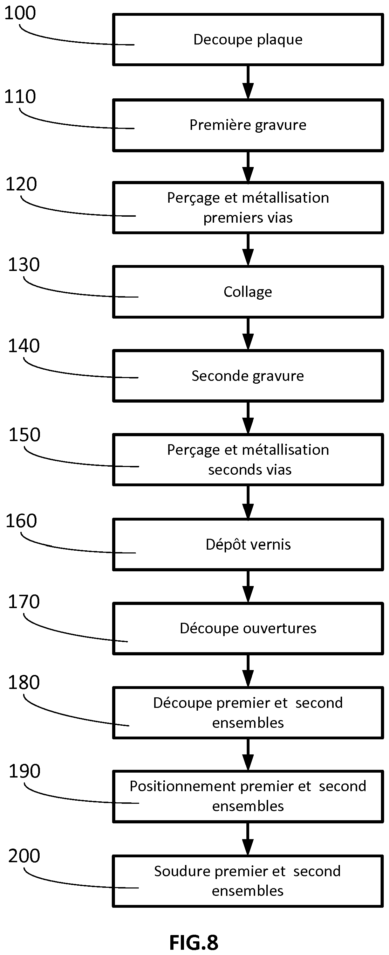

- la figure 8 représente un organigramme d'un procédé de fabrication d'un dispositif de mesure du courant de l'invention.

### DESCRIPTION DETAILLEE DE MODES DE REALISATION PREFERES

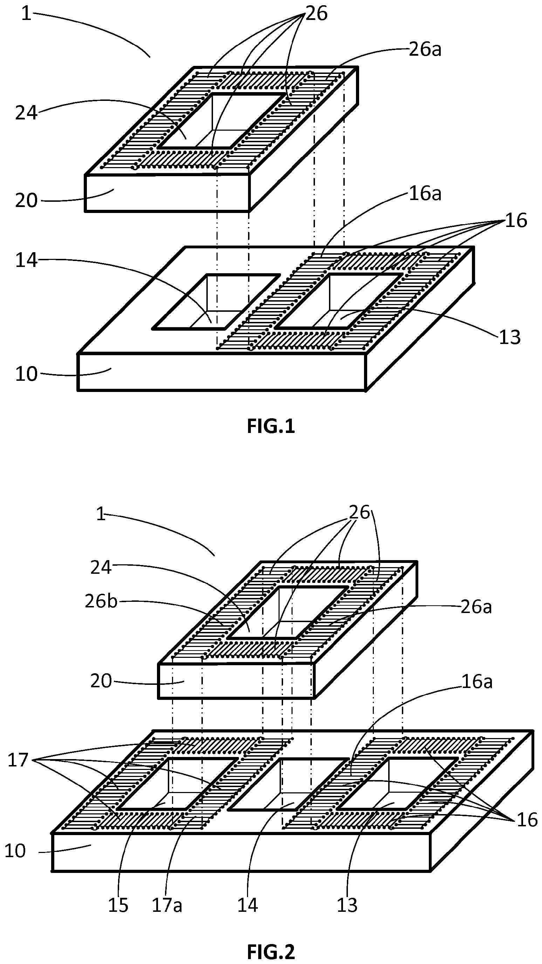

La figure 1 est une vue en perspective d'un dispositif de mesure du courant 1 selon un premier mode de réalisation. Le dispositif de mesure 1 comprend un premier ensemble de circuit imprimé 10 comportant une première ouverture 13 pour permettre un passage d'une première ligne de courant 2, non représentée sur la figure 1. Le premier ensemble de circuit imprimé 10 comporte une deuxième ouverture 14 pour un passage d'une deuxième ligne de courant 3, non représentée sur la figure 1. Un premier capteur de courant 16 est disposé autour de la première ouverture 13 pour mesurer le courant circulant dans la première ligne de courant 2 traversant la première ouverture 13. Le premier capteur de courant 16 comporte un enroulement disposé autour de la première ouverture 13. Préférentiellement, une première portion rectiligne d'enroulement 16a est disposée entre la première ouverture 13 et la deuxième ouverture 14.

Le dispositif de mesure du courant 1 comprend un second ensemble de circuit imprimé 20, disposé parallèlement au premier ensemble de circuit imprimé 10. Le second ensemble de circuit imprimé 20 est rapporté sur le premier ensemble de circuit imprimé 10 c'est-à-dire que les faces cuivrées des premier et second ensembles de circuits imprimés sont parallèles entre elles. Le second ensemble de circuit imprimé 20 comporte une troisième ouverture 24. Selon l'invention, le premier ensemble de circuit imprimé 10 et le second ensemble de circuit imprimé 20 sont disposés de manière à ce que la troisième ouverture 24 soit positionnée en vis-à-vis de la deuxième ouverture 14 afin de permettre un passage de la deuxième ligne de courant 3 au travers de la deuxième ouverture 14 et de la troisième ouverture 24. Le premier ensemble de circuit imprimé 10 et le second ensemble de circuit imprimé 20 sont préférentiellement accolés l'un à l'autre, l'expression « disposée en vis-à-vis » correspond à une disposition de la deuxième ouverture 14 en face de la troisième ouverture 24 de façon à former un passage continu pour la deuxième ligne de courant 3. Un deuxième capteur de courant 26 est disposé autour de la troisième ouverture 24 pour mesurer le courant circulant dans la deuxième ligne de courant 3 traversant la troisième ouverture 24. Le deuxième capteur de courant 26 comporte un enroulement disposé autour de la troisième ouverture 24. Préférentiellement, une deuxième portion rectiligne d'enroulement 26a du deuxième capteur de courant 26 est disposée en vis-à-vis de la première portion rectiligne d'enroulement 16a du premier capteur de courant 16. L'expression « disposée en vis-à-vis » signifie que la direction de la deuxième portion rectiligne d'enroulement 26a est parallèle à la direction de la première portion rectiligne d'enroulement 16a. Le premier ensemble de circuit imprimé 10 et le second ensemble de circuit imprimé 20 étant préférentiellement accolés, la première portion rectiligne d'enroulement 16a du premier capteur de courant 16 et la deuxième portion rectiligne d'enroulement 26a du deuxième capteur de courant 26 sont accolées et disposées dans une même direction, les portions rectilignes d'enroulement 16a et 26a étant orientées selon des axes parallèles. Une telle disposition est illustrée en figure 1 par des traits pointillés entre les extrémités la première portion rectiligne d'enroulement 16a du premier capteur de courant 16 et la deuxième portion rectiligne d'enroulement 26a du deuxième capteur de courant 26.

Le dispositif de mesure du courant selon l'invention est préférentiellement destiné à une mesure du courant circulant dans chacune des lignes de courant d'un réseau triphasé. La figure 2 est une vue en perspective d'un dispositif de mesure du courant particulièrement adapté à une installation électrique triphasée. Pour cela, le premier ensemble de circuit imprimé 10 comporte une quatrième ouverture 15 destinée au passage d'une troisième ligne de courant 4. Un troisième capteur de courant 17 est formé dans le premier ensemble de circuit imprimé 10. Ledit troisième capteur de courant 17 est disposé autour de la quatrième ouverture 15 pour mesurer le courant circulant dans la troisième ligne de courant 4, ladite la troisième ligne de courant 4 traversant la quatrième ouverture 15. Le troisième capteur de courant 17 comporte un enroulement disposé autour de la quatrième ouverture 15, ledit enroulement comportant une troisième portion rectiligne 17a entre la quatrième ouverture 15 et la deuxième ouverture 14. Le deuxième capteur de courant 26 comporte une quatrième portion rectiligne d'enroulement 26b disposée pour être en vis-à-vis de la troisième portion rectiligne d'enroulement 17a du troisième capteur de courant 17. Ainsi, la première portion rectiligne d'enroulement 16a du premier capteur de courant 16 est située en vis-à-vis de la deuxième portion rectiligne d'enroulement 26a du deuxième capteur de courant 26 et la troisième portion rectiligne d'enroulement 17a du troisième capteur de courant 17 est située en vis-à-vis de la quatrième portion rectiligne d'enroulement 26b du deuxième capteur 26. Cette disposition avantageuse en quinconce des trois capteurs de courant 16, 26 et 17 permet une réalisation industrielle compacte : la distance entre les ouvertures 13 et 14 et la distance entre les ouvertures 14 et 15 est limitée à la largeur d'un seul enroulement de capteur de courant, les ouvertures 13, 14 et 15 peuvent être dimensionnées pour laisser un passage maximal aux lignes de courant 2, 3 et 4. D'autre part, le premier et le second ensemble de circuit imprimé 10, 20 sont accolés et forment ainsi un dispositif de mesure du courant peu épais et donc compact.

Avantageusement, les premier, deuxième et troisième capteurs 16, 26, 17 sont des capteurs de courant de type Rogowski. Un tel capteur comprend un support en matériau amagnétique et un enroulement entourant un conducteur électrique parcouru par un courant à mesurer. Les premier et second ensembles de circuit imprimé 10, 20 constituent le support amagnétique des capteurs de courant 16, 26, 17. Les enroulements des capteurs de courant 16, 26 et 17 sont réalisés au moyen de pistes conductrices en surface du circuit imprimé, les pistes d'une face d'un ensemble de circuit imprimé étant reliées aux pistes de la face opposée du même ensemble de circuit imprimé par des trous métallisés appelés aussi « traversées » ou encore « vias ». Cette technique est conventionnelle.

La réalisation industrielle d'un dispositif de mesure du courant 1 de l'invention pose plusieurs problèmes :
- positionner précisément, et de manière reproductible en grande série, la première portion rectiligne d'enroulement 16a en vis-à-vis de la deuxième portion rectiligne d'enroulement 26a et simultanément positionner la troisième portion rectiligne d'enroulement 17a en vis-à-vis de la quatrième portion rectiligne d'enroulement 26b, et
- assurer une isolation électrique d'une part entre la première portion rectiligne d'enroulement 16a du premier capteur de courant 16 et la deuxième portion rectiligne d'enroulement 26a et d'autre part entre la troisième portion rectiligne d'enroulement 17a et la quatrième portion rectiligne d'enroulement 26b.

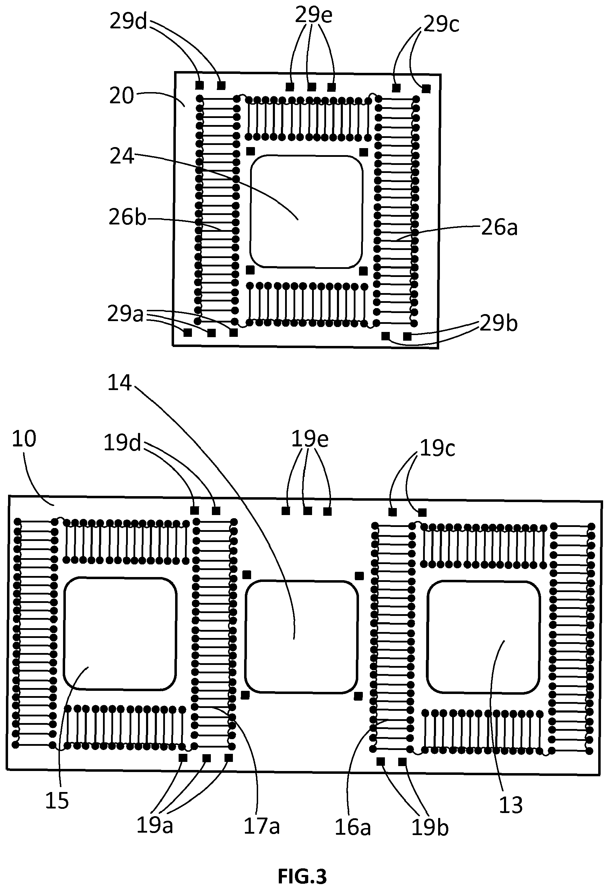

Pour résoudre le problème de précision de positionnement, le premier ensemble de circuit imprimé 10 comporte des premières plages de soudure 19a, 19b, 19c, 19d, le second ensemble de circuit imprimé 20 comporte des secondes plages de soudure 29a, 29b, 29c, 29d ainsi que représenté sur la figure 3. Chacune des premières plages de soudure 19a, 19b, 19c, 19d est disposée respectivement en vis-à-vis des secondes plages de soudure 29a, 29b, 29c, 29d. Par exemple, les premières plages de soudure 19a sont en vis-à-vis des secondes plages de soudure 29a, les premières plages de soudure 19b sont en vis-à-vis des secondes plages de soudure 29b et ainsi de suite. Les plages de soudure sont tracées par une méthode de sérigraphie ce qui garantit un positionnement très précis et reproductible desdites plages. Un dépôt de pâte à braser est effectué sur les plages de soudure avant de souder le second ensemble de circuit imprimé 20 sur le premier ensemble de circuit imprimé 10 puis le second ensemble de circuit imprimé 20 est positionné sur le premier ensemble de circuit imprimé 10. Un passage dans un four de refusion fait fondre la pâte à braser. Celle-ci crée un lien liquide entre les plages de soudure disposées en vis-à-vis et affine le positionnement du second ensemble de circuit imprimé 20 sur le premier ensemble de circuit imprimé 10 par l'action de tension superficielle. De cette façon la deuxième portion rectiligne d'enroulement 26a est disposée précisément en vis-à-vis de la première portion rectiligne d'enroulement 16a. De la même façon, la quatrième portion rectiligne d'enroulement 26b est disposée en vis-à-vis de la troisième portion rectiligne d'enroulement 17a. Cette solution technique ne nécessite pas de guide mécanique et ne nécessite pas de pièce supplémentaire.

Lors de la liquéfaction de la pâte à braser au moment de la soudure, la masse du second ensemble de circuit imprimé 20 a tendance à écraser la soudure liquide et la deuxième portion rectiligne d'enroulement 26a risque de venir en contact avec la première portion rectiligne d'enroulement 16a, ce qui est néfaste au fonctionnement du dispositif de mesure du courant. Il existe un risque identique de contact entre la quatrième portion rectiligne d'enroulement 26b et la troisième portion rectiligne d'enroulement 17a. Pour assurer une isolation électrique entre les portions d'enroulement situées en vis-à-vis, la somme des surfaces des plages de soudure 29a, 29b, 29c, 29d du second ensemble de circuit imprimé 20 est supérieure à 3% de la surface d'une face du second ensemble de circuit imprimé 20. De cette façon, la quantité de pâte à braser répandue sur les plages de soudure est suffisante pour maintenir le second ensemble de circuit imprimé 20 à une distance du premier ensemble de circuit imprimé 10 de l'ordre de 100 à 125 microns. Le refroidissement de la pâte à braser fige de manière durable la position du second ensemble de circuit imprimé 20 par rapport au premier ensemble de circuit imprimé 10. Il n'y a ainsi pas de risque de contact entre les différentes portions d'enroulement. De plus, les plages de soudure 29a, 29b, 29c, 29d sont réparties le plus uniformément possible sur la surface du second ensemble de circuit imprimé 20 de façon à répartir uniformément la masse du second ensemble de circuit imprimé 20 sur l'ensemble des plages de soudure 29a, 29b, 29c, 29d. Des plages supplémentaires de connexion 19e et 29e sont disposées respectivement sur le premier ensemble de circuit imprimé 10 et sur le sur le second ensemble de circuit imprimé 20 pour assurer la connexion électrique du deuxième capteur de courant 26 à un circuit de mesure 51.

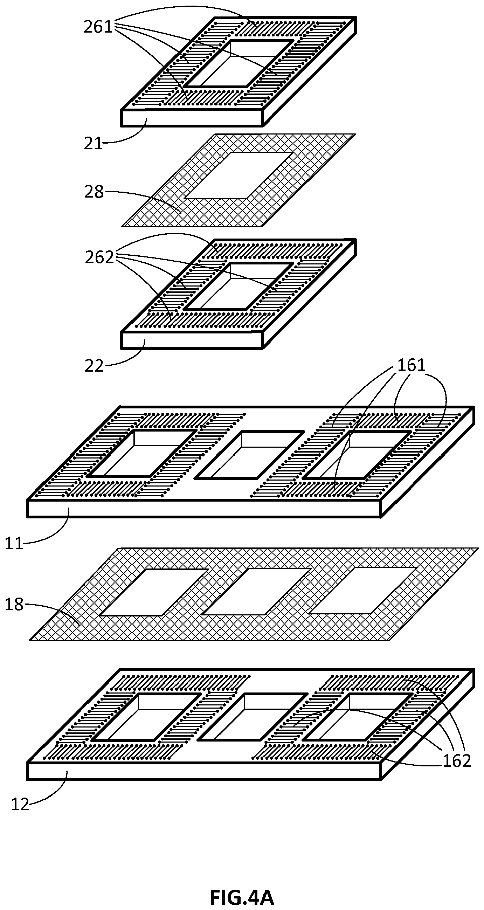

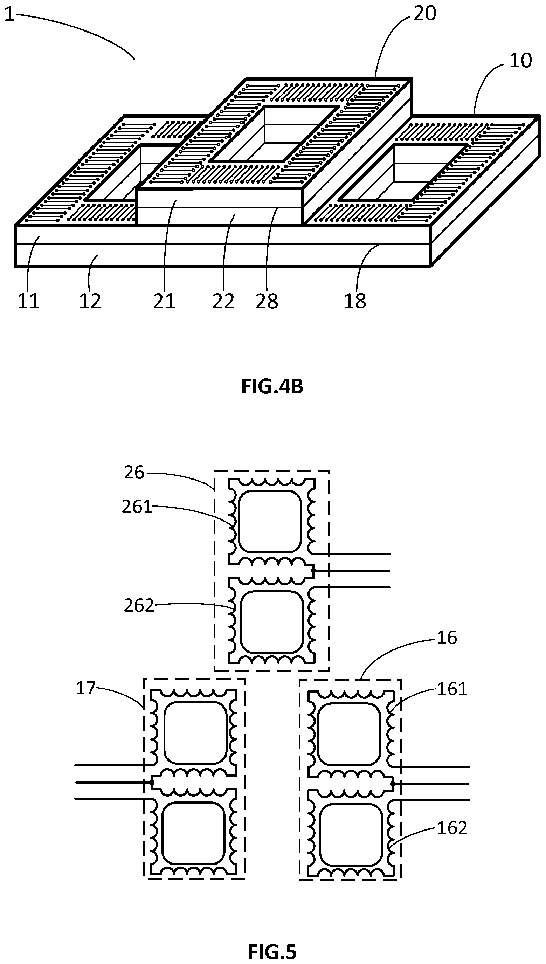

Dans une installation triphasée, la grande proximité entre les différentes lignes de courant 2, 3, 4 et les capteurs de courant 16, 17, 26 peut être source de perturbation des mesures de courant. Afin de limiter toute influence parasite, ainsi que représenté en figure 4A, le premier ensemble de circuit imprimé 10 est formé par un premier circuit imprimé 11 collé à un deuxième circuit imprimé 12 au moyen d'un premier tissu pré-imprégné de résine 18. Avantageusement, au cours de l'opération de collage, la résine remplit les vias des premiers et deuxième circuits imprimés 11, 12 et assure un bouchage desdits vias après polymérisation de la résine. Cette opération favorise un dépôt uniforme de vernis épargne sur les faces du premier ensemble de circuit imprimé au cours d'une étape ultérieure de fabrication. Le premier circuit imprimé 11 est le support d'un premier enroulement 161, le deuxième circuit imprimé est le support d'un deuxième enroulement 162. Le premier enroulement 161 et le deuxième enroulement 162 font partie du premier capteur de courant 16. Le premier enroulement 161 et le deuxième enroulement 162 constituent une première et une deuxième couche de bobines de même encombrement. L'orientation des spires du premier enroulement 161 et du deuxième enroulement 162 est, de préférence, telle que décrite dans le document EP 3 171 182 A1. Le premier enroulement 161 et le deuxième enroulement 162 sont disposés en vis-à-vis ainsi que représenté en figure 4A. De la même façon, le second ensemble de circuit imprimé 20 est formé par un troisième circuit imprimé 21 collé à un quatrième circuit imprimé 22 au moyen d'un second tissu pré-imprégné de résine 28, la résine assurant également un bouchage des vias des troisième et quatrième circuits imprimés 21, 22. Le second circuit imprimé 12 est le support d'un troisième enroulement 261, le quatrième circuit imprimé 22 est le support d'un quatrième enroulement 262. Le troisième enroulement 261 et le quatrième enroulement 262 font partie du deuxième capteur de courant 26 et sont disposés de manière similaire au premier enroulement 161 et au deuxième enroulement 162. En particulier, le troisième enroulement 261 et le quatrième enroulement 262 ont le même encombrement. Le troisième capteur de courant 17 est construit et disposé de façon similaire au premier capteur de courant 16. Les schémas de connexion des enroulements composant les capteurs de courant 16, 17 et 26 sont représentés en figure 5. Le premier enroulement 161 et le deuxième enroulement 162 du premier capteur de courant 16 sont connectés en série. De la même façon, le troisième enroulement 261 et le quatrième enroulement 262 sont connectés en série.

Les premier, deuxième troisième et quatrième circuits imprimés 11, 12, 21 et 22 sont avantageusement des circuits imprimés double face dont le coût est faible. L'association deux à deux des circuits imprimés est économiquement beaucoup plus intéressante que l'emploi d'un seul circuit imprimé en technologie multicouches. De plus, l'emploi d'un premier et d'un second tissu pré-imprégné 18, 28 apportent, sans surcoût et sans opération industrielle supplémentaire, une isolation électrique entre respectivement les premier et deuxième enroulements 161, 162 et entre le troisième et le quatrième enroulement 261, 262.

Le dispositif de mesure du courant 1 doit être tel que, pour un même courant circulant dans les lignes de courant, le signal fournit par tous les capteurs de courant doit être le même. Les capteurs étant de type Rogowski, le signal fourni est dépendant de la surface des spires des enroulements desdits capteurs. Pour assurer une surface constante et uniforme des spires de tous les capteurs de courant du dispositif de mesure 1, les premier, deuxième, troisième et quatrième circuits imprimés 11, 12, 21, 22 sont fabriqués à partir d'une même plaque de circuit imprimé. De cette façon, l'épaisseur des premier, deuxième, troisième et quatrième circuits imprimés 11, 12, 21, 22 est identique. D'autre part, les enroulements sont formés par une technique de gravure des couches de cuivre déposées en surface des circuits imprimés. Cette technique de gravure bénéficie d'une très grande précision et finesse due à son utilisation au stade industriel pour la fabrication d'équipements électroniques. De cette façon, la variation de surface des spires des enroulements des capteurs de courant 161, 162, 261, 262 d'un même dispositif de mesure du courant 1 est extrêmement faible, la variation de signal délivré par deux capteurs de courant d'un même dispositif de mesure 1 sera également extrêmement faible. Ce mode de fabrication du dispositif de mesure du courant 1 se prête donc à une réalisation en grande série industrielle. Préférentiellement, la plaque de circuit imprimé a une épaisseur supérieure à 1,5 millimètre pour maximiser la surface des spires des enroulements des capteurs. Les épaisseurs 1,56 mm ou 2 mm sont des épaisseurs standardisées.

Un vernis épargne, déposé sur les faces des premier et second ensembles de circuit imprimé, isole en particulier les spires des enroulements 161 et 262 et évite tout contact entre lesdits enroulements 161 et 262.

La figure 4B est une vue en perspective du dispositif de mesure du courant 1 après la soudure du second ensemble de circuit imprimé 20 sur le premier ensemble de circuit imprimé 10. Le dispositif de mesure du courant 1 représenté correspond à un mode de réalisation préférentiel destiné à la mesure du courant pour un réseau triphasé. Un tel dispositif est particulièrement adapté pour être implanté dans un appareil de mesure du courant.

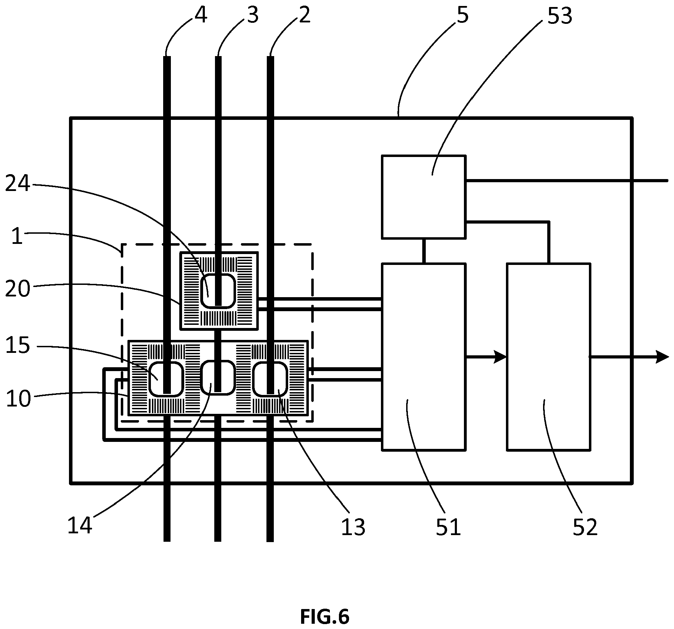

L'invention concerne également un appareil de mesure 5 destiné à la mesure du courant circulant dans, au moins, deux lignes de courant 2, 3 d'une installation électrique. Un tel appareil de mesure 5, comme illustré en figure 6, comporte :
- un circuit de mesure 51 pour mesurer l'amplitude de signaux électriques,
- un circuit de communication 52 relié au circuit de mesure 51 pour transmettre des résultats de mesure des signaux mesurés,
- un circuit d'alimentation 53 pour alimenter le circuit de mesure 51 et le circuit de communication 52, et
- un dispositif de mesure du courant 1 tel que décrit précédemment.

Le dispositif de mesure du courant 1 est connecté au circuit de mesure 51 pour fournir audit circuit de mesure des signaux représentatifs des courants circulant dans les, au moins deux, lignes de courant 2, 3. Pour cela, la première ligne de courant 2 passe dans la première ouverture 13 du premier ensemble de circuit imprimé 10. La deuxième ligne de courant 3 passe dans la deuxième ouverture 14 du premier ensemble de circuit imprimé 10 et passe dans la troisième ouverture 24 du second ensemble de circuit imprimé 20. S'il existe une troisième ligne de courant 4, celle-ci passe dans la quatrième ouverture 15 du premier ensemble de circuit imprimé 10.

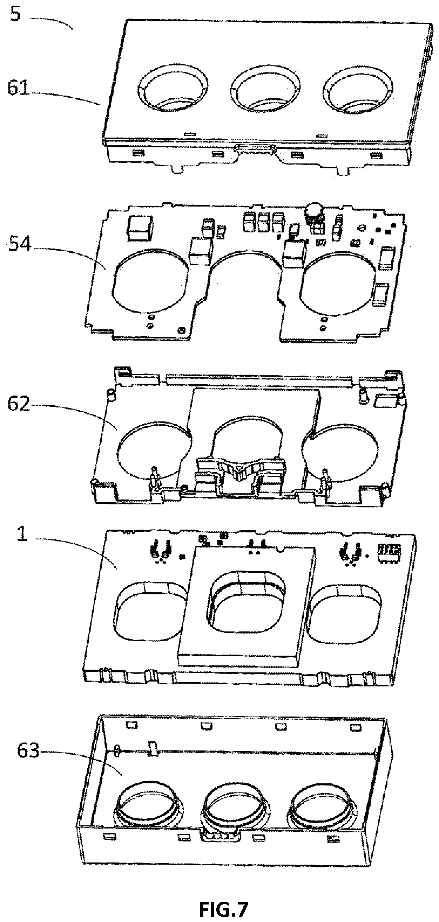

Une réalisation industrielle d'un appareil de mesure 5 est représentée sous forme d'une vue éclatée en figure 7. Le dispositif de mesure du courant 1 est maintenu mécaniquement dans un premier demi boitier 63. Avantageusement, certains composants du circuit de mesure 51 sont implantés sur les premier, deuxième, troisième et quatrième circuits imprimés 11, 12, 21, 22 au plus près des capteurs de courant 16, 26, 17 afin de réduire la distance entre les capteurs et le circuit de mesure. L'immunité des capteurs de courant aux perturbations externes est ainsi renforcée. Les circuits de communication 52 et d'alimentation 53 sont regroupés sur une carte électronique 54. Un module en matière isolante sépare le dispositif de mesure du courant 1 de la carte électronique 54. Les connexions électriques préférentiellement filaires entre le dispositif de mesure du courant 1 et la carte électronique 54 ne sont pas représentée sur la figure 7. Un second demi boitier 61 assure le maintien mécanique de la carte électronique 54. Les premier et second demi-boitiers 61 et 63 assurent un centrage du dispositif de mesure du courant 1 autour des lignes de courant 2, 3 et 4 et également une protection et une isolation électrique du dispositif de mesure du courant 1 et de la carte électronique 54 vis-à-vis de l'utilisateur et des équipements environnants.

L'invention concerne également un procédé de fabrication d'un dispositif de mesure du courant 1 tel que décrit précédemment. Le procédé de fabrication comporte les étapes suivantes :
- la découpe 100 d'une plaque mère de circuit imprimé en une première plaque destinée à la réalisation des premier et troisième circuits imprimés 11, 21 et une seconde plaque de circuit imprimé destinée à la réalisation des second et quatrième circuits imprimés 12, 22,
- la première gravure 110, sur une première face de la première plaque, de premières pistes correspondant aux premier et troisième enroulements 161, 261 du premier et du, moins un, deuxième capteur de courant 16, 26 et la gravure sur la seconde plaque de circuit imprimé, de premières pistes correspondant aux deuxième et quatrième enroulements 162, 262 du premier et du, au moins un deuxième capteur de courant 16, 26,
- le perçage et la métallisation 120 de premiers vias pour connecter les premières pistes à des secondes pistes gravées ultérieurement sur des secondes faces des plaques de circuit imprimé,
- le collage 130 de la première plaque de circuit imprimé avec la seconde plaque de circuit imprimé au moyen d'un premier tissu 18 pré-imprégné de résine, la première face de la première plaque étant en vis-à-vis de la première face de la seconde plaque de circuit imprimé,
- la seconde gravure 140, sur une seconde face de la première plaque, de secondes pistes correspondant aux premier et troisième enroulements 161, 261 et la gravure sur une seconde face la seconde plaque de circuit imprimé, de secondes pistes correspondant aux deuxième et quatrième enroulements 162, 262,
- le perçage et la métallisation 150 de seconds vias pour connecter les pistes entre la première face et la seconde face de la première plaque et de la seconde plaque de circuit imprimé,
- le dépôt d'un vernis épargne 160 sur la seconde face de la première plaque et sur la seconde face de la seconde plaque de circuit imprimé,
- la découpe 170 d'au moins une première et d'une deuxième ouverture 13, 14,
- la découpe 180 d'un premier ensemble de circuit imprimé 10 et d'un second ensemble de circuit imprimé 20,
- le positionnement 190 du second ensemble de circuit imprimé 20 sur le premier ensemble de circuit imprimé 10 de telle sorte qu'au moins une deuxième portion rectiligne d'enroulement 26a du deuxième capteur de courant 26 soit disposée en vis-à-vis d'une première portion rectiligne d'enroulement 16a du premier capteur de courant 16, et
- la soudure 200 du second ensemble de circuit imprimé 20 sur le premier ensemble de circuit imprimé 10.

En variante, il est possible de démarrer le procédé de fabrication par l'étape de première gravure 110 puis l'étape de perçage et métallisation 120 avant de passer à l'étape de découpe 100 de la plaque mère de circuit imprimé.

Un tel dispositif de mesure du courant électrique circulant dans des lignes d'une installation électrique, en particulier une installation triphasée, est particulièrement compact et fournit des mesures précises, peu influencées par des perturbations externes. Une fabrication industrielle économique peut être réalisée en grande série sur une chaîne de fabrication de cartes électroniques utilisant la technologie du circuit imprimé.

## Revendications

1. Dispositif de mesure du courant (1) circulant dans au moins deux lignes de courant (2,3) d'une installation électrique **caractérisé en ce qu'**il comprend :
- un premier ensemble de circuit imprimé (10) comportant :
- une première ouverture (13) pour un passage d'une première ligne de courant (2),
- une deuxième ouverture (14) pour un passage d'une deuxième ligne de courant (3), et
- un premier capteur de courant (16) disposé autour de la première ouverture (13) pour mesurer le courant circulant dans la première ligne de courant (2), ledit premier capteur de courant comportant au moins une première portion rectiligne d'enroulement (16a) disposée entre la première ouverture (13) et la deuxième ouverture (14),
- un second ensemble de circuit imprimé (20), disposé parallèlement au premier ensemble de circuit imprimé (10), ledit second ensemble comportant :
- une troisième ouverture (24), en vis-à-vis de la deuxième ouverture (14), pour un passage de la deuxième ligne de courant (3),
- un deuxième capteur de courant (26) disposé autour de la troisième ouverture (24) pour mesurer le courant circulant dans la deuxième ligne de courant (3) traversant la troisième ouverture (24), ledit deuxième capteur (26) comportant au moins une deuxième portion rectiligne d'enroulement (26a) disposée en vis-à-vis de la première portion rectiligne d'enroulement (16a) du premier capteur de courant (16).

2. Dispositif de mesure du courant (1) selon la revendication 1 **caractérisé en ce que** :
- le premier ensemble de circuit imprimé (10) comporte une quatrième ouverture (15) destinée au passage d'une troisième ligne de courant (4),
- un troisième capteur de courant (17), formé dans le premier ensemble de circuit imprimé (10), est disposé autour de la quatrième ouverture (15) pour mesurer le courant circulant dans la troisième ligne de courant (4), et que
- le troisième capteur de courant (17) comporte au moins une troisième portion rectiligne d'enroulement (17a) disposée entre la deuxième ouverture (14) et la quatrième ouverture (15).

3. Dispositif de mesure du courant (1) selon l'une des revendications 1 ou 2 **caractérisé en ce que** les premier, deuxième et troisième capteurs (16, 26, 17) sont des capteurs de courant de type Rogowski.

4. Dispositif de mesure du courant (1) selon l'une des revendications précédentes **caractérisé en ce que** le deuxième capteur de courant (26) comporte une quatrième portion rectiligne d'enroulement (26b) disposée en vis-à-vis de la troisième portion rectiligne d'enroulement (17a) du troisième capteur de courant (17).

5. Dispositif de mesure du courant (1) selon l'une des revendications 3 ou 4 **caractérisé en ce que** le premier ensemble de circuit imprimé (10) comporte des premières plages de soudure (19a, 19b, 19c, 19d), et que le second ensemble de circuit imprimé (20) comporte des secondes plages de soudure (29a, 29b, 29c, 29d) disposées en vis-à-vis des premières plages de soudure (19a, 19b, 19c, 19d) pour souder le second ensemble de circuit imprimé (20) sur le premier ensemble de circuit imprimé (10) de telle sorte que la deuxième portion rectiligne d'enroulement (26a) soit disposée en vis-à-vis de la première portion rectiligne d'enroulement (16a) et que la quatrième portion rectiligne d'enroulement (26b) soit disposée en vis-à-vis de la troisième portion rectiligne d'enroulement (17a).

6. Dispositif de mesure du courant (1) selon la revendication 5 **caractérisé en ce que** la somme des surfaces des plages de soudure (29a, 29b, 29c, 29d) du second ensemble de circuit imprimé (20) est supérieure à 3% de la surface d'une face du second ensemble de circuit imprimé (20).

7. Dispositif de mesure du courant (1) selon l'une quelconque des revendications 1 à 6 **caractérisé en ce que** le premier ensemble de circuit imprimé (10) est formé par un premier circuit imprimé (11) collé à un deuxième circuit imprimé (12) au moyen d'un premier tissu pré-imprégné de résine (18) et que le second ensemble de circuit imprimé (20) est formé par un troisième circuit imprimé (21) collé à un quatrième circuit imprimé (22) au moyen d'un second tissu pré-imprégné de résine (28).

8. Dispositif de mesure du courant (1) selon la revendication 7 **caractérisé en ce que** :
- le premier capteur de courant (16) comprend un premier enroulement (161) formé dans le premier circuit imprimé (11) et comprend un deuxième enroulement (162) formé dans le deuxième circuit imprimé (12), le premier enroulement (161) et le deuxième enroulement (162) ayant le même encombrement et étant connectés en série, et que
- le deuxième capteur de courant (26) comprend un troisième enroulement (261) formé dans le troisième circuit imprimé (21) et comprend un quatrième enroulement (262) formé dans le quatrième circuit imprimé (22), le troisième enroulement (261) et le quatrième enroulement (262) ayant le même encombrement et étant connectés en série.

9. Dispositif de mesure du courant (1) selon la revendication 8 **caractérisé en ce que** les premier, deuxième, troisième et quatrième circuits imprimés (11, 12, 21, 22) sont fabriqués à partir d'une même plaque de circuit imprimé.

10. Dispositif de mesure du courant (1) selon la revendication 9 **caractérisé en ce que** la plaque de circuit imprimé a une épaisseur supérieure à 1,5 millimètre.

11. Dispositif de mesure du courant (1) selon l'une quelconque des revendications précédentes **caractérisé en ce que** le premier ensemble de circuit imprimé (10) et le second ensemble de circuit imprimé (20) comportent des faces recouvertes d'un verni épargne.

12. Appareil de mesure (5) du courant circulant dans, au moins, deux lignes de courant (2, 3) d'une installation électrique, ledit appareil de mesure (5) comportant :
- un circuit de mesure (51) pour mesurer l'amplitude de signaux électriques,
- un circuit de communication (52) relié au circuit de mesure (51) pour transmettre des résultats de mesure des signaux mesurés, et
- un circuit d'alimentation (53) pour alimenter le circuit de mesure (51) et le circuit de communication (52),
**caractérisé en ce qu'**il comporte un dispositif de mesure du courant (1) selon l'une des revendications 1 à 11, connecté au circuit de mesure (51) pour fournir audit circuit de mesure des signaux représentatifs des courants circulant dans les, au moins deux, lignes de courant (2, 3), une première ligne de courant (2) passant dans une première ouverture (13) du dispositif de mesure du courant (1) et une deuxième ligne de courant (3) passant dans une deuxième ouverture (14) et une troisième ouverture (24) du dispositif de mesure du courant (1).

13. Procédé de fabrication d'un dispositif de mesure du courant (1) selon l'une des revendications 1 à 11, **caractérisé en ce que** ledit procédé comporte les étapes suivantes :
- la découpe (100) d'une plaque mère de circuit imprimé en une première plaque destinée à la réalisation des premier et troisième circuits imprimés 11, 21 et une seconde plaque de circuit imprimé destinée à la réalisation des second et quatrième circuits imprimés 12, 22,
- la première gravure (110), sur une première face de la première plaque, de premières pistes correspondant aux premier et troisième enroulements (161, 261) d'un premier et d'au moins un deuxième capteur de courant (16, 26) et la gravure sur la seconde plaque de circuit imprimé, de premières pistes correspondant aux deuxième et quatrième enroulements (162, 262) d'un premier et d'au moins un deuxième capteur de courant (16, 26),
- le perçage et la métallisation (120) de premiers vias pour connecter les premières pistes,
- le collage (130) de la première plaque de circuit imprimé avec la seconde plaque de circuit imprimé au moyen d'un premier tissu (18) pré-imprégné de résine, la première face de la première plaque étant en vis-à-vis de la première face de la seconde plaque de circuit imprimé,
- la seconde gravure (140), sur une seconde face de la première plaque, de secondes pistes correspondant aux premier et troisième enroulements (161, 261) et la gravure sur une seconde face la seconde plaque de circuit imprimé, de secondes pistes correspondant aux deuxième et quatrième enroulements (162, 262),
- le perçage et la métallisation (150) de seconds vias pour connecter les pistes entre la première face et la seconde face de la première plaque et de la seconde plaque de circuit imprimé,
- le dépôt d'un vernis épargne (160) sur la seconde face de la première plaque et sur la seconde face de la seconde plaque de circuit imprimé,
- la découpe (170) d'au moins une première et d'une deuxième ouverture (13, 14),
- la découpe (180) d'un premier ensemble de circuit imprimé (10) et d'un second ensemble de circuit imprimé (20),
- le positionnement (190) du second ensemble de circuit imprimé (20) sur le premier ensemble de circuit imprimé (10) de telle sorte qu'au moins une deuxième portion rectiligne d'enroulement (26a) du deuxième capteur de courant (26) soit disposée en vis-à-vis d'une première portion rectiligne d'enroulement (16a) du premier capteur de courant (16), et
- la soudure (200) du second ensemble de circuit imprimé (20) sur le premier ensemble de circuit imprimé (10).

## Patentansprüche

1. Strommessvorrichtung (1) zum Messen des in mindestens zwei Stromleitungen (2, 3) einer elektrischen Anlage fließenden Stroms, **dadurch gekennzeichnet, dass** sie umfasst:
- eine erste Leiterplattenanordnung (10), umfassend:
- eine erste Öffnung (13) für einen Durchgang einer ersten Stromleitung (2),
- eine zweite Öffnung (14) für einen Durchgang einer zweiten Stromleitung (3), und
- einen ersten Stromsensor (16), der um die erste Öffnung (13) herum angeordnet ist, um den in der ersten Stromleitung (2) fließenden Strom zu messen, wobei der erste Stromsensor mindestens einen ersten geraden Windungsabschnitt (16a) umfasst, der zwischen der ersten Öffnung (13) und der zweiten Öffnung (14) angeordnet ist,
- eine zweite Leiterplattenanordnung (20), die parallel zur ersten Leiterplattenanordnung (10) angeordnet ist, wobei die zweite Anordnung umfasst:
- eine dritte Öffnung (24) gegenüber der zweiten Öffnung (14) für einen Durchgang der zweiten Stromleitung (3),
- einen zweiten Stromsensor (26), der um die dritte Öffnung (24) herum angeordnet ist, um den in der zweiten Stromleitung (3) durch die dritte Öffnung (24) fließenden Strom zu messen, wobei der zweite Sensor (26) mindestens einen zweiten geraden Windungsabschnitt (26a) umfasst, der dem ersten geraden Windungsabschnitt (16a) des ersten Stromsensors (16) gegenüberliegt.

2. Strommessvorrichtung (1) nach Anspruch 1, **dadurch gekennzeichnet, dass**:
- die erste Leiterplattenanordnung (10) eine vierte Öffnung (15) für den Durchgang einer dritten Stromleitung (4) aufweist,
- ein dritter Stromsensor (17), der in der ersten Leiterplattenanordnung (10) ausgebildet ist, um die vierte Öffnung (15) herum angeordnet ist, um den in der dritten Stromleitung (4) fließenden Strom zu messen, und dass
- der dritte Stromsensor (17) mindestens einen dritten geraden Windungsabschnitt (17a) umfasst, der zwischen der zweiten Öffnung (14) und der vierten Öffnung (15) angeordnet ist.

3. Strommessvorrichtung (1) nach Anspruch 1 oder 2, **dadurch gekennzeichnet, dass** der erste, zweite und dritte Sensor (16, 26, 17) Stromsensoren vom Rogowski-Typ sind.

4. Strommessvorrichtung (1) nach einem der vorhergehenden Ansprüche, **dadurch gekennzeichnet, dass** der zweite Stromsensor (26) einen vierten geraden Windungsabschnitt (26b) aufweist, der dem dritten geraden Windungsabschnitt (17a) des dritten Stromsensors (17) gegenüberliegt.

5. Strommessvorrichtung (1) nach einem der Ansprüche 3 oder 4, **dadurch gekennzeichnet, dass** die erste Leiterplattenanordnung (10) erste Lötbereiche (19a, 19b, 19c, 19d) und die zweite Leiterplattenanordnung (20) zweite Lötbereiche (29a, 29b, 29c, 29d) aufweisen, die den ersten Lötbereichen (19a, 19b, 19c, 19d) gegenüberliegen, um die zweite Leiterplattenanordnung (20) an der ersten Leiterplattenanordnung (10) zu verlöten, so dass der zweite gerade Windungsabschnitt (26a) gegenüber dem ersten geraden Windungsabschnitt (16a) und der vierte gerade Windungsabschnitt (26b) gegenüber dem dritten geraden Windungsabschnitt (17a) angeordnet ist.

6. Strommessvorrichtung (1) nach Anspruch 5, **dadurch gekennzeichnet, dass** die Summe der Oberflächen der Lötbereiche (29a, 29b, 29c, 29d) der zweiten Leiterplattenanordnung (20) größer als 3 % der Oberfläche einer Seite der zweiten Leiterplattenanordnung (20) ist.

7. Strommessvorrichtung (1) nach einem der Ansprüche 1 bis 6, **dadurch gekennzeichnet, dass** die erste Leiterplattenanordnung (10) durch eine erste Leiterplatte (11) ausgebildet ist, die mit einer zweiten Leiterplatte (12) mittels eines ersten mit Harz vorimprägnierten Gewebes (18) verbunden ist, und dass die zweite Leiterplattenanordnung (20) durch eine dritte Leiterplatte (21) ausgebildet ist, die mit einer vierten Leiterplatte (22) mittels eines zweiten mit Harz vorimprägnierten Gewebes (28) verbunden ist.

8. Strommessvorrichtung (1) nach Anspruch 7, **dadurch gekennzeichnet, dass**:
- der erste Stromsensor (16) eine erste Windung (161) umfasst, die in der ersten Leiterplatte (11) ausgebildet ist, und eine zweite Windung (162) umfasst, die in der zweiten Leiterplatte (12) ausgebildet ist, wobei die erste Windung (161) und die zweite Windung (162) die gleiche Größe aufweisen und in Reihe geschaltet sind, und
- der zweite Stromsensor (26) eine dritte Windung (261) umfasst, die in der dritten Leiterplatte (21) ausgebildet ist, und eine vierte Windung (262) umfasst, die in der vierten Leiterplatte (22) ausgebildet ist, wobei die dritte Windung (261) und die vierte Windung (262) die gleiche Größe aufweisen und in Reihe geschaltet sind.

9. Strommessvorrichtung (1) nach Anspruch 8, **dadurch gekennzeichnet, dass** die erste, zweite, dritte und vierte Leiterplatte (11, 12, 21, 22) aus derselben Leiterplatte hergestellt sind.

10. Strommessvorrichtung (1) nach Anspruch 9, **dadurch gekennzeichnet, dass** die Leiterplatte eine Dicke von mehr als 1,5 mm aufweist.

11. Strommessvorrichtung (1) nach einem der vorhergehenden Ansprüche, **dadurch gekennzeichnet, dass** die erste Leiterplattenanordnung (10) und die zweite Leiterplattenanordnung (20) Seiten aufweisen, die mit einem Sparlack bedeckt sind.

12. Vorrichtung zum Messen (5) des in mindestens zwei Stromleitungen (2, 3) einer elektrischen Anlage fließenden Stroms, wobei die Messvorrichtung (5) umfasst:
- eine Messschaltung (51) zum Messen der Amplitude von elektrischen Signalen,
- eine mit der Messschaltung (51) verbundene Kommunikationsschaltung (52) zum Übertragen von Messergebnissen der Messsignale und
- eine Stromversorgungsschaltung (53) zum Versorgen der Messschaltung (51) und der Kommunikationsschaltung (52),
**dadurch gekennzeichnet, dass** sie eine Strommessvorrichtung (1) nach einem der Ansprüche 1 bis 11 umfasst, die mit der Messschaltung (51) verbunden ist, um die Messschaltung mit Signalen zu versorgen, die für die in den mindestens zwei Stromleitungen (2, 3) fließenden Ströme repräsentativ sind, wobei eine erste Stromleitung (2) durch eine erste Öffnung (13) der Strommessvorrichtung (1) und eine zweite Stromleitung (3) durch eine zweite Öffnung (14) und eine dritte Öffnung (24) der Strommessvorrichtung (1) verläuft.

13. Verfahren zur Herstellung einer Strommessvorrichtung (1) nach einem der Ansprüche 1 bis 11, **dadurch gekennzeichnet, dass** das Verfahren die folgenden Schritte umfasst:
- Schneiden (100) einer Mutterleiterplatte in eine erste Platte zum Herstellen der ersten und dritten Leiterplatte 11, 21 und einer zweiten Leiterplatte zum Herstellen der zweiten und vierten Leiterplatte 12, 22,
- erstes Ätzen (110) auf einer ersten Seite der ersten Platte von ersten Spuren, die den ersten und dritten Windungen (161, 261) eines ersten und mindestens eines zweiten Stromsensors (16, 26) entsprechen, und Ätzen auf der zweiten Leiterplatte von ersten Spuren, die den zweiten und vierten Windungen (162, 262) eines ersten und mindestens eines zweiten Stromsensors (16, 26) entsprechen,
- Bohren und Metallisieren (120) der ersten Kontaktlöcher, um die ersten Spuren zu verbinden,
- Verkleben (130) der ersten Leiterplatte mit der zweiten Leiterplatte mittels eines ersten mit Harz vorimprägnierten Gewebes (18), wobei die erste Seite der ersten Leiterplatte der ersten Seite der zweiten Leiterplatte gegenüberliegt,
- zweites Ätzen (140) auf einer zweiten Seite der ersten Platte von zweiten Spuren, die den ersten und dritten Windungen (161, 261) entsprechen, und Ätzen auf einer zweiten Seite der zweiten Leiterplatte von zweiten Spuren, die den zweiten und vierten Windungen (162, 262) entsprechen,
- Bohren und Metallisieren (150) von zweiten Kontaktlöchern, um die Spuren zwischen der ersten und der zweiten Seite der ersten und zweiten Leiterplatte zu verbinden,
- Absetzen eines Sparlackes (160) auf der zweiten Seite der ersten Platte und auf der zweiten Seite der zweiten Leiterplatte,
- Schneiden (170) mindestens einer ersten und einer zweiten Öffnung (13, 14),
- Schneiden (180) einer ersten Leiterplattenanordnung (10) und einer zweiten Leiterplattenanordnung (20),
- Positionieren (190) der zweiten Leiterplattenanordnung (20) auf der ersten Leiterplattenanordnung (10), so dass mindestens ein zweiter gerader Windungsabschnitt (26a) des zweiten Stromsensors (26) gegenüber einem ersten geraden Windungsabschnitt (16a) des ersten Stromsensors (16) angeordnet ist, und
- Verlöten (200) der zweiten Leiterplattenanordnung (20) auf der ersten Leiterplattenanordnung (10).

## Claims

1. Device (1) for measuring the current flowing in at least two current lines (2, 3) of an electrical installation, **characterized in that** it comprises:
- a first printed circuit assembly (10) including:
- a first aperture (13) for passing a first current line (2),
- a second aperture (14) for passing a second current line (3), and
- a first current sensor (16) positioned around the first aperture (13) so as to measure the current flowing in the first current line (2), said first current sensor including at least one first rectilinear winding portion (16a) positioned between the first aperture (13) and the second aperture (14),
- a second printed circuit assembly (20), positioned parallel to the first printed circuit assembly (10), said second assembly including:
- a third aperture (24), facing the second aperture (14), for passing the second current line (3),
- a second current sensor (26) positioned around the third aperture (24) so as to measure the current flowing in the second current line (3) passing through the third aperture (24), said second sensor (26) including at least one second rectilinear winding portion (26a) positioned facing the first rectilinear winding portion (16a) of the first current sensor (16).

2. Device (1) for measuring current according to Claim 1, **characterized in that**:
- the first printed circuit assembly (10) includes a fourth aperture (15) intended for passing a third current line (4),
- a third current sensor (17), formed in the first printed circuit assembly (10), is positioned around the fourth aperture (15) so as to measure the current flowing in the third current line (4), and that
- the third current sensor (17) includes at least one third rectilinear winding portion (17a) positioned between the second aperture (14) and the fourth aperture (15).

3. Device (1) for measuring current according to either one of Claims 1 and 2, **characterized in that** the first, second and third sensors (16, 26, 17) are Rogowski type current sensors.

4. Device (1) for measuring current according to any one of the preceding claims, **characterized in that** the second current sensor (26) includes a fourth rectilinear winding portion (26b) positioned facing the third rectilinear winding portion (17a) of the third current sensor (17).

5. Device (1) for measuring current according to either one of Claims 3 or 4, **characterized in that** the first printed circuit assembly (10) includes first soldering pads (19a, 19b, 19c, 19d), and that the second printed circuit assembly (20) includes second soldering pads (29a, 29b, 29c, 29d) positioned facing the first soldering pads (19a, 19b, 19c, 19d) so as to solder the second printed circuit assembly (20) on the first printed circuit assembly (10) such that the second rectilinear winding portion (26a) is positioned facing the first rectilinear winding portion (16a) and the fourth rectilinear winding portion (26b) is positioned facing the third rectilinear winding portion (17a).

6. Device (1) for measuring current according to Claim 5, **characterized in that** the sum of the surface areas of the soldering pads (29a, 29b, 29c, 29d) of the second printed circuit assembly (20) is greater than 3% of the surface area of a side of the second printed circuit assembly (20).

7. Device (1) for measuring current according to any one of Claims 1 to 6, **characterized in that** the first printed circuit assembly (10) is formed by a first printed circuit (11) bonded to a second printed circuit (12) by means of a first ply (18) pre-impregnated with resin and that the second printed circuit assembly (20) is formed by a third printed circuit (21) bonded to a fourth printed circuit (22) by means of a second ply (28) pre-impregnated with resin.

8. Device (1) for measuring current according to Claim 7, **characterized in that**:
- the first current sensor (16) comprises a first winding (161) formed in the first printed circuit (11) and comprises a second winding (162) formed in the second printed circuit (12), the first winding (161) and the second winding (162) having the same spatial requirement and being connected in series, and that
- the second current sensor (26) comprises a third winding (261) formed in the third printed circuit (21) and comprises a fourth winding (262) formed in the fourth printed circuit (22), the third winding (261) and the fourth winding (262) having the same spatial requirement and being connected in series.

9. Device (1) for measuring current according to Claim 8, **characterized in that** the first, second, third and fourth printed circuits are (11, 12, 21, 22) are manufactured from the same printed circuit board.

10. Device (1) for measuring current according to Claim 9, **characterized in that** the printed circuit board has a thickness greater than 1.5 millimetres.

11. Device (1) for measuring current according to any one of the preceding claims, **characterized in that** the first printed circuit assembly (10) and the second printed circuit assembly (20) include sides coated with a solder mask.

12. Unit (5) for measuring the current flowing in at least two current lines (2, 3) of an electrical installation, said measuring unit (5) including:
- a measuring circuit (51) for measuring the amplitude of electrical signals,
- a communication circuit (52) connected to the measuring circuit (51) so as to transmit measurement results of the measured signals, and
- a power supply circuit (53) for powering the measuring circuit (51) and the communication circuit (52),
**characterized in that** it includes a device (1) for measuring current according to any one of Claims 1 to 11, connected to the measuring circuit (51) so as to deliver to said measuring circuit signals representative of the currents flowing in the, at least two, current lines (2, 3), a first current line (2) passing in a first aperture (13) of the device (1) for measuring current and a second current line (3) passing in a second aperture (14) and a third aperture (24) of the device (1) for measuring current.

13. Method for manufacturing a device (1) for measuring current according to any one of Claims 1 to 11, **characterized in that** said method includes the following steps:
- cutting (100) a printed circuit motherboard into a first board intended to make the first and third printed circuits (11, 21) and a second printed circuit board intended to make the second and fourth printed circuits (12, 22),
- the first etching (110), on a first side of the first board, of first tracks corresponding to the first and third windings (161, 261) of the first and of at least one second current sensor (16, 26), and etching on the second printed circuit board, of first tracks corresponding to the second and fourth windings (162, 262) of a first and of at least one second current sensor (16, 26),
- drilling and metallization (120) of first vias for connecting the first tracks,
- bonding (130) the first printed circuit board to the second printed circuit board by means of a first ply (18) pre-impregnated with resin, the first side of the first board facing the first side of the second printed circuit board,
- the second etching (140) on a second side of the first board, of second tracks corresponding to the first and third windings (161, 261) and etching on a second side of the second printed circuit board, of second tracks corresponding to the second and fourth windings (162, 262),
- drilling and metallization (150) of second vias for connecting the tracks between the first side and the second side of the first and of the second printed circuit boards,
- applying a solder mask (160) on the second side of the first board and on the second side of the second printed circuit board,
- cutting (170) at least one first and one second aperture (13, 14),
- cutting (180) a first printed circuit assembly (10) and a second printed circuit assembly (20),
- positioning (190) the second printed circuit assembly (20) on the first printed circuit assembly (10) such that at least one second rectilinear winding portion (26a) of the second current sensor (26) is positioned facing a first rectilinear winding portion (16a) of the first current sensor (16), and
- soldering (200) the second printed circuit assembly (20) to the first printed circuit assembly (10).
